# FASCICULE DE BREVET EUROPEEN

(11) **EP 4 040 677 B1**
(45) Date de publication et mention de la délivrance du brevet: **09.04.2025**
(21) Numéro de dépôt: 22154413.3
(22) Date de dépôt: 01.02.2022
(51) Int. Cl.: H03K 17/18, H03K 19/007, H04L 25/02, H03K 17/95

(54) **DISPOSITIF ÉLECTRONIQUE DE GESTION DE BUS KNX OU ANALOGUE, AVEC PROTECTION DE COMPOSANT ÉLECTRONIQUE**
ELEKTRONISCHES GERÄT ZUR STEUERUNG VON KNX-BUSSEN ODER ÄHNLICHEM, MIT SCHUTZ DES ELEKTRONISCHEN BAUTEILS
ELECTRONIC DEVICE FOR MANAGING KNX BUS OR SIMILAR, WITH PROTECTION OF ELECTRONIC COMPONENT

(30) Priorité: 05.02.2021 FR 2101112
(43) Date de publication de la demande: 10.08.2022
(73) Titulaire: HAGER CONTROLS, 67700 Saverne (FR)
(72) Inventeur: ELSASS, Marc, 67140 BARR (FR); POUJAUD, Laurent, 67330 HATTMATT (FR); WANNER, Jean-Marc, 67550 VENDENHEIM (FR)
(74) Mandataire: Cabinet Nuss

(56) Documents cités:
- EP-A2- 2 720 053
- STMICROELECTRONICS: "Miniature KNX transceiver with voltage regulators and microcontroller support", 8 February 2012 (2012-02-08), XP055843595, Retrieved from the Internet <URL:https://eu.mouser.com/pdfdocs/enDM00454674.pdf> [retrieved on 20210922]

## Description

La présente invention concerne le domaine de la sécurité électrique, plus particulièrement la sécurité électrique dans la domotique et a pour objet un dispositif électronique de gestion de bus KNX ou analogue, avec protection de composant électronique. Elle a également pour objet un procédé de protection de composant électronique dans un dispositif électronique de gestion de bus KNX ou analogue.

Dans le domaine électrique, on sait que les produits commercialisés doivent garantir la sécurité des biens et des personnes et, dans ce cadre, être conformes aux normes de sécurité en vigueur.

Pour les produits électroniques, les normes précisent que tous les composants électroniques, sauf quelques composants de sécurité certifiés, doivent être considérés comme pouvant être défectueux en court-circuit ou en circuit ouvert. De ce fait des essais sont nécessaires pour s'assurer que les produits ne présentent pas de danger en cas de court-circuit ou de circuit ouvert des composants électroniques. Plus particulièrement, en cas de défaillance d'un composant électronique, lorsque la température dépasse une température élevée pendant une certaine durée, par exemple 300°C sur un circuit imprimé (ou PCB de l'anglais printed circuit board) pendant une durée de plus de 30 secondes, on considère qu'il peut y avoir un départ de feu préjudiciable, sauf si une enveloppe contre le feu, telle qu'une armoire ou un coffret, répondant à l'ensemble des critères normatifs, est utilisée pour protéger le produit.

Toutefois, il est toléré de tester uniquement les composants électroniques jugés critiques, c'est-à-dire les composants électroniques pour lesquels il est estimé, qu'en cas de défaut, ils peuvent présenter un risque.

Si les risques sont généralement évalués dans les circuits directement connectés sur le réseau de distribution électrique, ils sont également évalués dans des circuits très basse tension tels que les circuits très basse tension de sécurité (TBTS).

Dans le cadre de l'évaluation des risques dans ces circuits très basse tension, sont concernés : les bus de terrain, par opposition aux bus informatiques. Parmi les bus de terrain, un bus connu est le bus KNX qui relie les automates aux composants dans une installation domotique. Le bus KNX est un bus deux fils sur lequel on superpose une alimentation à courant continu, généralement de 29 ou 30V, découplée par des inductances avec des données qui sont transmises de manière impulsionnelle, à une fréquence déterminée, via une résistance, généralement comprise entre 27 et 68 ohms, dite résistance d'émission.

Le bus KNX est particulièrement adapté pour la domotique et notamment le contrôle de bâtiments en permettant à de nombreux composants ou appareils, du même fabricant ou de fabricants différents, installés et reliés entre eux dans ces bâtiments, de communiquer l'un avec l'autre. Le bus KNX permet donc de contrôler différentes applications domotiques avec un seul système.

La gestion du bus KNX ou analogue est réalisé par un circuit électronique à courant pulsé comprenant un point de connexion audit bus pour la transmission des données à ce dernier, une résistance d'émission et un circuit électronique d'émission des données comportant une sortie d'émission, dite sortie TXO, et étant apte et destiné à délivrer à ladite sortie d'émission un signal d'émission des données pulsé. La sortie TXO est connectée audit point de connexion via la résistance d'émission précitée. Le signal de transmission de données est appelé par la suite signal TXO. Un tel circuit électronique d'émission des données, à base de microprocesseur ou microcontrôleur, est, par exemple, commercialisé, sous la référence NCN5121.

En fonctionnement normal d'un tel circuit électronique d'émission des données :

- hors émission du signal TXO, la sortie TXO est ouverte/déconnectée dans ledit circuit de commande par un moyen du type transistor, jusqu'au prochain pulse d'émission, c'est-à-dire sur une durée dite durée OFF. Aucun courant ne circule alors dans cette sortie TXO, ni dans la résistance d'émission,

- lors de l'émission du signal TXO, la sortie TXO est court-circuitée à la masse dans le circuit électronique d'émission le temps de la durée du pulse d'émission, dite durée ON.

Ainsi la résistance d'émission connectée à la sortie TXO ne conduit du courant électrique que pendant la durée ON des pulses d'émission. Or ces pulses d'émission sont très courts, c'est-à-dire que la durée ON est très inférieure à la durée OFF de sorte que le rapport cyclique, c'est-à-dire la durée le rapport de la durée ON sur la durée OFF, est très faible. En conséquence, la puissance moyenne dissipée dans la résistance d'émission est très faible puisqu'elle ne conduit du courant que pendant chaque pulse et que la durée de chaque pulse est faible.

La résistance d'émission est par conséquent choisie par les fabricants en tenant compte de ce fonctionnement. Dans l'exemple du circuit NCN5121 précité, le document correspondant fourni par le constructeur recommande une résistance d'émission de 27 ohms pour une puissance maximale à ne pas dépasser de 1W. D'autres fabricants utilisent des résistances du type CMS (composant à montage en surface) avec une puissance maximale à ne pas dépasser de 1 ou 2W. Ces valeurs sont largement suffisantes pour garantir, en fonctionnement normal, la fiabilité et le bon fonctionnement de la résistance d'émission.

Toutefois, dans le cas où le fonctionnement n'est plus normal, c'est-à-dire en cas de défaillance du circuit électronique d'émission, avec la sortie TXO court-circuitée à la masse de façon permanente, la puissance dissipée dans la résistance d'émission peut atteindre des valeurs allant jusqu'à 13 à 33 W en permanence. La puissance dissipée dans ce cas dépend aussi de l'alimentation utilisée sur le bus KNX et des autres produits ou appareils connectés sur ledit bus. De telles puissances peuvent générer des départs de feu et poser de véritables problèmes de sécurité. En effet, à de telles puissances, la température dans la résistance d'émission peut atteindre des valeurs comprises entre 300 et 600°C. La norme française NF, par exemple, utilisée dans un grand nombre de produits domotiques intégrant des actionneurs, considère qu'il peut y avoir un danger de feu dès 0.5W de puissance dissipée lors d'une défaillance.

Par ailleurs, les normes de sécurité actuelles, telles que par exemple les normes européennes EN60669, EN60730, EN60950, etc. exigent que les fabricants valident l'absence de risque sécuritaire, y compris la surchauffe excessive, pour tous les composants.

Pour remédier à ces inconvénients, plusieurs solutions peuvent être envisagées pour répondre au cas où le signal TXO est court-circuité de façon permanente suite à une défaillance :

Une première solution consisterait à prévoir une résistance d'émission de taille beaucoup plus grande pour qu'elle puisse rester dans des températures raisonnables n'entraînant pas de surchauffe excessive générant des départs de feu. Toutefois, une taille importante de la résistance irait à l'encontre des objectifs de miniaturisation que veulent atteindre les fabricants aujourd'hui et serait incompatible avec la dimension des cartes électroniques utilisées actuellement.

Une deuxième solution serait d'utiliser une résistance fusible qui s'ouvrirait rapidement en cas de surchauffe excessive. Cependant cette solution serait quasiment impossible car une telle résistance ne devrait pas s'altérer lors de pics de puissance pendant les pulses de transmission de données, tout en étant capable de s'ouvrir pour la même puissance appliquée plus longuement en cas de défaillance du circuit. La fiabilité du produit avec une telle résistance fusible serait ainsi remise en question.

Une troisième solution serait de dimensionner un fusible monté dans le circuit en série avec la résistance d'émission pour qu'il s'ouvre en cas de courant excessif, mais cette solution ne fonctionnerait pas car le courant de défaut est le même que les pics de courant durant l'émission d'une communication KNX. La différence se situerait uniquement sur la durée de maintien du courant.

Une quatrième solution consisterait à utiliser un fusible thermique pour protéger la résistance et le circuit en cas de surchauffe excessive. Toutefois, si cette solution permet d'améliorer la sécurité du circuit, elle pose des problèmes d'inertie thermique du fusible thermique et impose d'importantes contraintes de couplage thermique entre la résistance d'émission et le fusible thermique. En outre, cette protection ne s'enclencherait que lorsque la température devient critique dans le circuit. La reproductibilité lors de la réutilisation d'un produit à l'autre ne serait pas assurée, cette solution pouvant nécessiter une phase de mise au point différente sur chaque produit dans lequel on souhaite l'intégrer.

Le document Internet « Stmicroelectronics : « Miniature KNX transceiver with voltage regulators and microcontroller support » du 8 février 2012, a pour objet un transmetteur miniature KNX comprenant un transmetteur, une branche de connexion à un bus KNX comprenant une sortie du transmetteur, une résistance de limitation de courant RTX et un point de connexion audit bus (Cathode de la diode).

Toutefois, ce transmetteur ne permet pas de réaliser la protection de la résistance de limitation de courant RTX en évitant toute surchauffe excessive, potentiellement dangereuse, de cette dernière lorsque la sortie d'émission est court-circuitée à la masse de manière permanente lors d'une défaillance du circuit électronique d'émission des données.

La présente invention a pour but de pallier ces inconvénients en proposant un dispositif électronique de gestion de bus KNX ou analogue, avec protection de composant électronique permettant d'éviter toute surchauffe excessive, potentiellement dangereuse, de la résistance d'émission ou de tout autre élément de limitation de courant analogue.

A cet effet, le dispositif électronique, selon la présente invention, de gestion de bus KNX ou analogue, avec protection de composant électronique, ledit dispositif comprenant un circuit électronique principal à courant pulsé apte et destiné à gérer la transmission des données dans un bus KNX ou analogue dans lequel est superposée une alimentation continue avec lesdites données, ledit circuit électronique principal comprenant, d'une part, un circuit électronique d'émission des données comportant une sortie d'émission et étant apte et destiné à délivrer à ladite sortie d'émission un signal d'émission des données pulsé et, d'autre part, un point de connexion audit bus pour la transmission desdites données à ce dernier et une résistance d'émission, ou autre élément de limitation de courant analogue, à travers laquelle passe ledit signal, ladite sortie d'émission étant mise transitoirement, à chaque pulse, dans un état de court-circuit en étant court-circuitée à la masse dans ledit circuit électronique d'émission des données et, entre deux pulses, dans un état de circuit ouvert, se caractérise essentiellement en ce qu'il comprend en outre un circuit de protection électronique configuré et connecté audit circuit électronique principal de sorte à surveiller l'état de ladite sortie d'émission pour détecter un état de cette dernière, dit état de court-circuit permanent, où celle-ci est court-circuitée à la masse de manière permanente, c'est-à-dire avec une durée au moins supérieure à celle d'un pulse ou d'un train de pulses, suite à une défaillance éventuelle du circuit électronique d'émission des données et à déclencher instantanément, suite à ladite détection, une ouverture dans une branche dudit circuit électronique principal, entre ladite sortie d'émission et le point de connexion, ayant pour effet d'interrompre instantanément la circulation du courant électrique dans ladite résistance d'émission.

La présente invention a également pour objet un procédé de protection de composant électronique dans un dispositif électronique de gestion de bus KNX ou analogue, ledit dispositif comprenant un circuit électronique principal à courant pulsé apte et destiné à gérer la transmission des données dans un bus KNX ou analogue dans lequel est superposée une alimentation continue avec lesdites données, ledit circuit électronique principal comprenant, d'une part, un circuit électronique d'émission des données comportant une sortie d'émission et étant apte et destiné à délivrer à ladite sortie d'émission un signal d'émission des données pulsé et, d'autre part, un point de connexion audit bus pour la transmission desdites données à ce dernier et une résistance d'émission, ou autre élément de limitation de courant analogue, à travers laquelle passe ledit signal, ladite sortie d'émission étant mise transitoirement, à chaque pulse, dans un état de court-circuit en étant court-circuitée à la masse dans ledit circuit électronique d'émission des données et, entre deux pulses, dans un état de circuit ouvert, se caractérisant essentiellement en ce qu'il consiste à surveiller l'état de ladite sortie d'émission pour détecter un état de la sortie d'émission, dit état de court-circuit permanent, où celle-ci est court-circuité à la masse de manière permanente, c'est-à-dire avec une durée au moins supérieure à celle d'un pulse ou d'un train de pulses, suite à une défaillance éventuelle du circuit électronique d'émission des données et à déclencher instantanément, suite à ladite détection, une ouverture dans une branche dudit circuit électronique principal, entre ladite sortie d'émission et le point de connexion, ayant pour effet d'interrompre instantanément la circulation du courant électrique dans ladite résistance d'émission.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
[Fig. 1] est une représentation fonctionnelle ou synoptique du dispositif électronique, selon la présente invention, de gestion de bus KNX ou analogue,
[Fig. 2] montre le schéma électronique du dispositif représenté sur la figure 1, dans un mode de réalisation préférentiel du schéma électronique circuit de protection.

Les figures annexées montrent un dispositif électronique, selon la présente invention, de gestion de bus KNX ou analogue, avec protection de composant électronique, ledit dispositif comprenant un circuit électronique principal 1 à courant pulsé apte et destiné à gérer la transmission des données dans un bus KNX ou analogue dans lequel est superposée une alimentation continue avec lesdites données. Le circuit électronique principal 1 comprend, d'une part, un circuit électronique d'émission des données 1a comportant une sortie, dite sortie 10a d'émission, et étant apte et destiné à délivrer à ladite sortie 10a d'émission un signal d'émission des données pulsé et, d'autre part, un point de connexion audit bus pour la transmission desdites données à ce dernier et une résistance R1, dite résistance R1 d'émission, ou autre élément de limitation de courant analogue, à travers laquelle (ou lequel) passe ledit signal d'émission des données.

Un bus analogue à un bus KNX est un bus qui reprend le principe de fonctionnement électronique du bus KNX. D'autre part, il est bien connu comme élément de limitation de courant analogue à une telle résistance R1 d'émission, par exemple, un limiteur de courant à transistor.

Le circuit électronique d'émission des données 1a peut être un circuit intégré ou discret.

La sortie d'émission est mise transitoirement (ou temporairement) :
- à chaque pulse, dans un état de court-circuit en étant court-circuitée à la masse dans ledit circuit électronique d'émission des données,
- et, entre deux pulses, dans un état de circuit ouvert.

Conformément à la présente invention, un tel dispositif de gestion comprend en outre un circuit de protection 3, 4 électronique configuré et connecté audit circuit électronique principal 1 de sorte :
- à surveiller l'état de ladite sortie 10a d'émission pour détecter un état de cette dernière, dit état de court-circuit permanent, où celle-ci est court-circuitée à la masse M de manière permanente (ou prolongée), c'est-à-dire avec une durée au moins supérieure à celle d'un pulse ou d'un train de pulses, suite à une défaillance éventuelle du circuit électronique d'émission des données 1a,
- et à déclencher instantanément, suite à ladite détection, une ouverture dans une branche 1c dudit circuit électronique principal 1, entre ladite sortie d'émission 10a et le point de connexion 1b, ayant pour effet d'interrompre instantanément la circulation du courant électrique dans ladite résistance R1 d'émission.

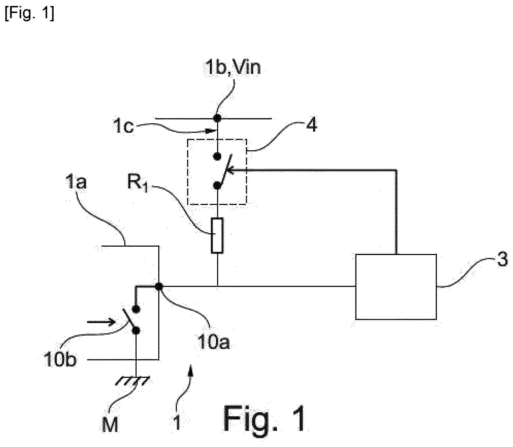

De manière connue, pour réaliser le court-circuit transitoire à la masse M dans le circuit électronique d'émission des données 1a, la sortie 10a d'émission est connectée dans ledit électronique de transmission 1a à un interrupteur électronique 10b relié à la masse M (figure 1) et commandé en fermeture pour court-circuiter transitoirement, à chaque pulse, ladite sortie 10a d'émission et en ouverture pour déconnecter transitoirement, entre deux pulses, ladite sortie 10a d'émission.

Un tel circuit électronique d'émission des données 1a, à base de microprocesseur ou microcontrôleur, peut être un circuit connu et commercialisé, par exemple, par la société « ON SEMI » sous la référence « NCN5121 » ou tout autre circuit équivalent.

Dans un mode de réalisation préférentiel, le circuit de protection 3, 4 comprend, d'une part, un circuit de détection et de commande 3 électronique et, d'autre part, un interrupteur électronique 4 de protection connecté dans ladite branche 1c et configuré pour être commandé dans un état de fermeture laissant le courant circuler dans ladite branche 1c et dans un état d'ouverture déclenchant l'ouverture de ladite branche 1c. Le circuit de détection et de commande 3 est configuré de sorte à détecter l'état de court-circuit permanent et, suite à ladite détection, à commander instantanément l'interrupteur électronique de protection 4 pour le mettre dans l'état d'ouverture et pour le maintenir dans l'état de fermeture lorsque ladite sortie 10a d'émission est mise transitoirement à l'état de court-circuit.

De préférence, l'interrupteur électronique de protection 4 est connecté dans la branche 1c entre la résistance R1 d'émission et le point de connexion 1c. L'interrupteur électronique de protection 4 peut alors être connecté en série avec la résistance R entre cette dernière et le point de connexion 1c.

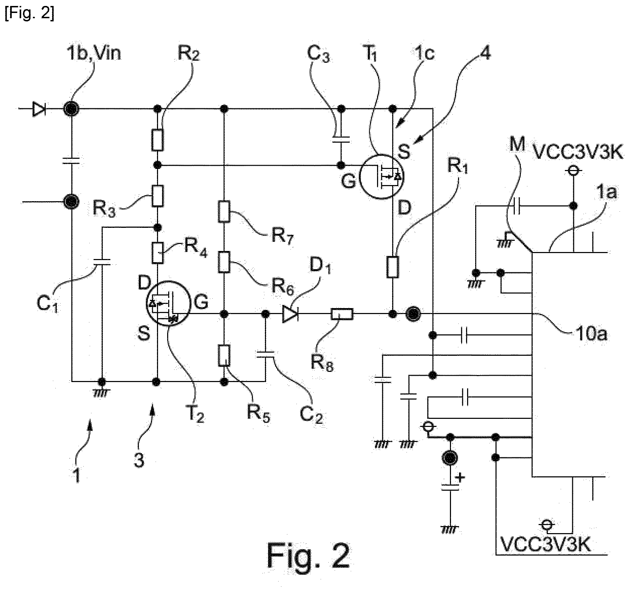

L'interrupteur électronique de protection 4 est préférentiellement un dispositif semi-conducteur T1 de la famille des transistors tel qu'un transistor T1 à effet de champ à grille isolée, plus couramment appelé MOSFET (selon l'acronyme anglais de Metal Oxide Semiconductor Field Effect Transistor) tel que représenté sur la figure 2 ou, non représenté sur les figures annexées, un transistor bipolaire ou tout autre technologie d'interrupteur électronique apte à fonctionner en commutation. Le transistor T1 à effet de champ à grille isolée peut être à enrichissement ou à appauvrissement et à canal N ou P.

Dans une première forme de réalisation, le circuit de détection et de commande 3 est un circuit électronique essentiellement à base de dispositif(s) semi-conducteur T2 de la famille des transistors, de résistance(s) R2, R3, R4, R5, R6, R7, R8, de condensateur(s) C1, C2, C3 et, éventuellement, de diode(s) D1.

En outre le circuit de détection et de commande 3 peut être configuré de sorte que le ou l'un des condensateur(s) C1 :
- lors de la détection de l'état de court-circuit permanent, se charge jusqu'à ce que la tension à ses bornes atteigne une tension, dite tension de commande, ayant pour effet de mettre à l'état d'ouverture l'interrupteur électronique de protection 4,
- lorsque la sortie 10a d'émission est mise transitoirement à l'état de court-circuit, se charge, à chaque pulse, sans que la tension à ses bornes n'ait le temps d'atteindre ladite tension de commande de sorte que l'interrupteur électronique de protection 4 est maintenu ou mis dans l'état de fermeture. On peut alors considérer que le circuit de protection est dans ce cas « transparent »,
- lorsque ladite sortie 10a d'émission est transitoirement, entre deux pulses, mise dans un état de circuit ouvert, se décharge de sorte que l'interrupteur électronique de protection 4 est maintenu ou mis dans l'état de fermeture.

Le dispositif semi-conducteur T2 peut être un transistor T2 à effet de champ à grille isolée tel que représenté sur la figure 2 ou, non représenté sur les figures annexées, un transistor bipolaire ou tout autre technologie d'interrupteur électronique apte à fonctionner en commutation. Le transistor T2 à effet de champ à grille isolée peut être à enrichissement ou à appauvrissement et à canal N ou P.

Comme on peut le voir sur la figure 2, dans une forme de réalisation préférentielle, le transistor T2 du circuit de détection et de commande 3 est un transistor T2 à effet de champ à grille isolée à enrichissement et à canal N et le transistor T1 formant l'interrupteur électronique de protection 4 est un transistor à effet de champ à grille isolée à enrichissement et à canal P.

Ainsi, dans la forme de réalisation préférentielle du schéma électronique du circuit de protection 3, 4 représenté sur la figure 2, le fonctionnement du dispositif électronique, selon la présente invention, selon que le fonctionnement est normal (sans défaillance du circuit électronique d'émission des données 1a conduisant à un court-circuit permanent de la sortie 10a d'émission) ou anormal (défaillance du circuit électronique d'émission des données 1a conduisant à l'état de court-circuit permanent de la sortie 10a d'émission) est le suivant, étant pris en considération la tension d'alimentation Vin :

En fonctionnement normal :
- sans émission des pulses : la sortie 10a d'émission du circuit électronique d'émission des données 1a est déconnectée, c'est-à-dire dans un état ouvert. Aucun courant ne circule dans ladite sortie 10a d'émission et aucun signal d'émission des données n'est délivré à cette sortie. La diode D1 est polarisée en inverse et le transistor T2 est polarisé de façon à conduire. La capacité C1 est alors déchargée et la différence de potentiel aux bornes de la résistance R2 et de la jonction grille source du transistor T1 est suffisamment élevée de façon à ce que le transistor T1 soit passant. Dans ce cas la résistance R1 d'émission est connectée à la tension Vin à travers le transistor T1,
- en émission : la sortie 10a d'émission est connectée transitoirement à la masse M dans le circuit électronique d'émission des données 1a à chaque pulse émis. La durée ON d'un pulse est très inférieure à la durée OFF entre deux pulses, de sorte que le rapport cyclique ON/OFF est très faible. De ce fait, la puissance moyenne dissipée dans la résistance R1 d'émission est également très faible et n'entraîne pas de surchauffe excessive de ladite résistance R1 d'émission pouvant poser un problème de sécurité. Lors des pulses d'émission la diode D1 conduit brièvement à chaque impulsion, mais la capacité C1 n'a pas le temps de se charger suffisamment pour mettre le transistor T1 à l'état bloqué, ce dernier restant alors passant. La résistance R1 d'émission est ainsi connectée directement à la tension Vin pendant les pulses d'émission.

En fonctionnement anormal : La sortie 10a d'émission est à l'état de court-circuit permanent et la diode D1 conduit en permanence, ce qui a pour effet de mettre le transistor T2 à l'état bloqué. La capacité C1 se charge, la tension aux bornes de la résistance R2 diminue et la tension grille du transistor T1 monte par rapport à la masse, ce qui a pour effet de réduire la tension grille source du transistor T1 dont la source est connectée à Vin et de mettre ce dernier à l'état bloqué. Du fait de l'état bloqué du transistor T1, c'est-à-dire de l'état ouvert de l'interrupteur électronique 4 de protection, formé ici par le transistor T1, la résistance R1 d'émission est ainsi déconnectée de Vin, évitant tout risque de surchauffe de ladite résistance R1 d'émission.

On comprend, même en tenant compte bien évidement des temps de connexion des différents composants électronique en présence et du temps de la charge du condensateur C1, qu'un court-circuit à la masse permanent de la sortie 10a d'émission est immédiatement détecté par le circuit de détection et de commande 3 et que l'interrupteur électronique 4 de protection est commandé instantanément, c'est-à-dire quasi instantanément, en ouverture dès ladite détection et bien avant que la résistance R1 n'ait le temps de surchauffer de manière excessive, c'est-à-dire en entraînant sa détérioration, voire le début d'un incendie. La protection du dispositif par le circuit de protection 3, 4 selon la présente invention est alors assurée. Un tel circuit de protection 3, 4 garantit ainsi le fonctionnement et la fiabilité du dispositif et élimine tout risque de départ éventuel d'incendie provoqué par une surchauffe excessive de la résistance R1 d'émission.

Dans une deuxième forme de réalisation, non représentée sur les figures annexées, le circuit de détection et de commande 3 comprend un dispositif électronique de mesure de durée (ou de temporisation) apte à mesurer la durée de l'état de court-circuit de la sortie 10a d'émission. En outre, le circuit de détection et de commande 3 est configuré pour traiter ladite durée mesurée en la comparant à la durée d'un pulse ou d'un train de pulses et, lorsque cette durée mesurée est supérieure à ladite durée d'un pulse ou d'un train de pulses, pour commander instantanément l'interrupteur électronique de protection 4 afin de le mettre dans l'état d'ouverture.

Toujours dans cette deuxième forme de réalisation, de préférence, le circuit de détection et de commande 3 peut comprendre un microcontrôleur ou tout autre circuit intégré analogue utilisé pour la mesure de durée ou la temporisation tel que, par exemple, un circuit intégré connu sous le nom de NE555 et couramment : nommé 555 ou encore un ASIC (acronyme de l'anglais « application-specific integrated circuit »). Le microcontrôleur, ou le circuit intégré analogue, inclut le dispositif de mesure de durée. Le microcontrôleur, ou le circuit intégré analogue, peut alors être configuré pour traiter ladite durée mesurée par le dispositif de mesure de durée en la comparant à la durée d'un pulse ou d'un train de pulses et, lorsque cette durée est au moins supérieure à ladite durée d'un pulse ou d'un train de pulses, pour commander instantanément l'interrupteur électronique de protection 4 afin de mettre ce dernier à l'état d'ouverture.

La présente invention a également pour objet un procédé de protection de composant électronique dans un dispositif électronique de gestion de bus KNX ou analogue, ledit dispositif comprenant le circuit électronique principal 1 à courant pulsé décrit précédemment.

Conformément à la présente invention, un tel procédé consiste :
- à surveiller l'état de la sortie 10a d'émission pour détecter un état de la sortie 10a d'émission, dit état de court-circuit permanent, où celle-ci est court-circuitée à la masse M de manière permanente suite à une défaillance éventuelle du circuit électronique d'émission des données 1a,
- et à déclencher instantanément, suite à ladite détection, une ouverture dans une branche 1c dudit circuit électronique principal 1, entre ladite sortie d'émission 10a et le point de connexion 1b, ayant pour effet d'interrompre instantanément la circulation du courant électrique dans ladite résistance R1 d'émission. On comprend qu'avant ladite ouverture, ladite branche 1c est préalablement dans un état fermé, ou mise dans état fermé, permettant la circulation du courant électrique dans ladite résistance R1 d'émission.

Dans une première forme de réalisation, le procédé peut consister à mesurer la durée de l'état de court-circuit de la sortie 10a d'émission et en ce que ledit circuit de détection et de commande 3 est configuré pour traiter ladite durée mesurée en la comparant à la durée d'un pulse ou d'un train de pulses et, lorsque cette durée mesurée est supérieure à ladite durée d'un pulse ou d'un train de pulses, pour commander instantanément l'interrupteur électronique de protection 4 afin de le mettre dans l'état d'ouverture.

Dans une deuxième forme de réalisation, le procédé peut consister :
- lors de l'état de court-circuit permanent, à charger un condensateur C1 jusqu'à ce que la tension à ses bornes atteigne une tension, dite tension de commande, ayant pour effet de déclencher l'ouverture de ladite branche 1c pour interrompre instantanément la circulation du courant électrique dans ladite résistance R1 d'émission,
- lorsque ladite sortie 10a d'émission est mise transitoirement à l'état de court-circuit, à charger, à chaque pulse, ledit condensateur C1, sans que la tension à ses bornes n'ait le temps d'atteindre la tension de commande de sorte à ne pas déclencher l'ouverture de ladite branche 1c d'émission pour permettre ou maintenir la circulation du courant électrique dans ladite résistance R1 d'émission,
- lorsque ladite sortie 10a d'émission est transitoirement, entre deux pulses, mise dans un état de circuit ouvert, à décharger ledit condensateur C1 de sorte à permettre ou maintenir la circulation du courant électrique dans ladite résistance R1 d'émission.

Le dispositif électronique de gestion, selon la présente invention, de gestion de bus KNX ou analogue, convient à ou permet la mise en œuvre d'un tel procédé.

Un tel dispositif ou procédé, selon la présente invention, qui permet la détection immédiate et l'ouverture instantanée du circuit dans la branche comprenant la résistance R1 d'émission suite à la détection de la mise en court-circuit permanent de la sortie 10a d'émission est beaucoup plus efficace qu'une solution utilisant un fusible thermique dont l'inertie thermique est très lente ou une méthode, utilisant par exemple un tel fusible, ouvrant le circuit lorsque le courant électrique dans celui-ci atteint ou dépasse une valeur d'intensité donnée durant un certain temps. Avec un fusible thermique le risque peut être réduit mais pas annulé contrairement au dispositif selon la présente invention.

## Revendications

1. Dispositif électronique de gestion de bus KNX ou analogue, avec protection de composant électronique, ledit dispositif comprenant un circuit électronique principal (1) à courant pulsé apte et destiné à gérer la transmission des données dans un bus KNX ou analogue dans lequel est superposée une alimentation continue avec lesdites données, ledit circuit électronique principal (1) comprenant, d'une part, un circuit électronique d'émission des données (1a) comportant une sortie (10a) d'émission et étant apte et destiné à délivrer à ladite sortie (10a) d'émission un signal d'émission des données pulsé et, d'autre part, un point de connexion (1b) audit bus pour la transmission desdites données à ce dernier et une résistance (R1) d'émission, ou autre élément de limitation de courant analogue, à travers laquelle passe ledit signal, ladite sortie (10a) d'émission étant mise transitoirement, à chaque pulse, dans un état de court-circuit en étant court-circuitée à la masse (M) dans ledit circuit électronique d'émission des données (1a) et, entre deux pulses, dans un état de circuit ouvert, **caractérisé en ce qu'**il comprend en outre un circuit de protection (3, 4) électronique configuré et connecté audit circuit électronique principal (1) de sorte à surveiller l'état de ladite sortie (10a) d'émission pour détecter un état de cette dernière, dit état de court-circuit permanent, où celle-ci est court-circuitée à la masse (M) de manière permanente, c'est-à-dire avec une durée au moins supérieure à celle d'un pulse ou d'un train de pulses, suite à une défaillance éventuelle du circuit électronique d'émission des données (1a) et à déclencher instantanément, suite à ladite détection, une ouverture dans une branche (1c) dudit circuit électronique principal (1), entre ladite sortie (10a) d'émission et le point de connexion (1b), ayant pour effet d'interrompre instantanément la circulation du courant électrique dans ladite résistance (R1) d'émission.

2. Dispositif électronique, selon la revendication 1, **caractérisé en ce que** le circuit de protection (3, 4) comprend, d'une part, un circuit de détection et de commande (3) électronique et, d'autre part, un interrupteur électronique (4) de protection connecté dans ladite branche (1c) et configuré pour être commandé dans un état de fermeture laissant le courant circuler dans ladite branche (1c) et dans un état d'ouverture déclenchant l'ouverture de ladite branche (1c), ledit circuit de détection et de commande (3) étant configuré de sorte à détecter l'état de court-circuit permanent et, suite à ladite détection, à commander instantanément l'interrupteur électronique de protection (4) pour le mettre dans l'état d'ouverture et pour le maintenir dans l'état de fermeture lorsque ladite sortie (10a) d'émission est mise transitoirement à l'état de court-circuit.

3. Dispositif électronique, selon la revendication 2, **caractérisé en ce que** l'interrupteur électronique de protection (4) est connecté dans la branche (1c) entre la résistance (R1) d'émission et le point de connexion (1b).

4. Dispositif électronique, selon la revendication 2 ou 3, **caractérisé en ce que** l'interrupteur électronique de protection (4) est un dispositif semi-conducteur de la famille des transistors tel qu'un transistor (T1) à effet de champ à grille isolée ou un transistor bipolaire.

5. Dispositif électronique, selon l'une quelconque des revendications 2 à 4, **caractérisé en ce que** le circuit de détection et de commande (3) comprend un dispositif électronique de mesure de durée apte à mesurer la durée de l'état de court-circuit de la sortie (10a) d'émission et **en ce que** ledit circuit de détection et de commande (3) est configuré pour traiter ladite durée mesurée en la comparant à la durée d'un pulse ou d'un train de pulses et, lorsque cette durée mesurée est supérieure à ladite durée d'un pulse ou d'un train de pulses, pour commander instantanément l'interrupteur électronique de protection (4) afin de le mettre dans l'état d'ouverture.

6. Dispositif électronique, selon la revendication 5, **caractérisé en ce que** le circuit de détection et de commande (3) comprend un microcontrôleur ou tout autre circuit intégré analogue utilisé pour la mesure de durée et **en ce que** ledit microcontrôleur, ou le circuit intégré analogue, inclut ledit dispositif de mesure de durée.

7. Dispositif électronique, selon l'une quelconque des revendications 2 à 4, **caractérisé en ce que** le circuit de détection et de commande (3) est un circuit électronique essentiellement à base de dispositif(s) semi-conducteur (T2) de la famille des transistors, de résistance(s) (R2, R3, R4, R5, R6, R7, R8) et de condensateur(s) (C1, C2, C3) et **en ce que** le circuit de détection et de commande (3) est configuré de sorte que le ou l'un des condensateur(s) (C1) :
- lors de la détection de l'état de court-circuit permanent, se charge jusqu'à ce que la tension à ses bornes atteigne une tension, dite tension de commande, ayant pour effet de mettre à l'état d'ouverture l'interrupteur électronique de protection (4),
- lorsque la sortie (10a) d'émission est mise transitoirement à l'état de court-circuit, se charge, à chaque pulse, sans que la tension à ses bornes n'ait le temps d'atteindre ladite tension de commande de sorte que l'interrupteur électronique de protection (4) est maintenu ou mis dans l'état de fermeture,
- lorsque ladite sortie (10a) d'émission est transitoirement, entre deux pulses, mise dans un état de circuit ouvert, se décharge de sorte que l'interrupteur électronique de protection (4) est maintenu ou mis dans l'état de fermeture.

8. Procédé de protection de composant électronique dans un dispositif électronique de gestion de bus KNX ou analogue, ledit dispositif comprenant un circuit électronique principal (1) à courant pulsé apte et destiné à gérer la transmission des données dans un bus KNX ou analogue dans lequel est superposée une alimentation continue avec lesdites données, ledit circuit électronique principal (1) comprenant, d'une part, un circuit électronique d'émission des données (1a) comportant une sortie (10a) d'émission et étant apte et destiné à délivrer à ladite sortie (10a) d'émission un signal d'émission des données pulsé et, d'autre part, un point de connexion (1b) audit bus pour la transmission desdites données à ce dernier et une résistance (R1) d'émission, ou autre élément de limitation de courant analogue, à travers laquelle passe ledit signal, ladite sortie (10a) d'émission étant mise transitoirement, à chaque pulse, dans un état de court-circuit en étant court-circuitée à la masse (M) dans ledit circuit électronique d'émission des données (1a) et, entre deux pulses, dans un état de circuit ouvert, **caractérisé en ce qu'**il consiste à surveiller l'état de ladite sortie (10a) d'émission pour détecter un état de la sortie (10a) d'émission, dit état de court-circuit permanent, où celle-ci est court-circuitée à la masse (M) de manière permanente, c'est-à-dire avec une durée au moins supérieure à celle d'un pulse ou d'un train de pulses, suite à une défaillance éventuelle du circuit électronique d'émission des données (1a) et à déclencher instantanément, suite à ladite détection, une ouverture dans une branche (1c) dudit circuit électronique principal (1), entre ladite sortie d'émission (10a) et le point de connexion (1b), ayant pour effet d'interrompre instantanément la circulation du courant électrique dans ladite résistance (R1) d'émission.

9. Procédé, selon la revendication 8, **caractérisé en ce qu'**il consiste à mesurer la durée de l'état de court-circuit de la sortie (10a) d'émission, à traiter ladite durée mesurée en la comparant à la durée d'un pulse ou d'un train de pulses et, lorsque cette durée mesurée est supérieure à ladite durée d'un pulse ou d'un train de pulses, à déclencher instantanément l'ouverture dans ladite branche 1c pour interrompre instantanément la circulation du courant électrique dans ladite résistance (R1) d'émission.

10. Procédé, selon la revendication 8, **caractérisé en ce qu'**il consiste :
- lors de l'état de court-circuit permanent, à charger un condensateur (C1) jusqu'à ce que la tension à ses bornes atteigne une tension, dite tension de commande, ayant pour effet de déclencher l'ouverture de ladite branche (1c) pour interrompre instantanément la circulation du courant électrique dans ladite résistance (R1) d'émission,
- lorsque ladite sortie (10a) d'émission est mise transitoirement à l'état de court-circuit, à charger, à chaque pulse, ledit condensateur (C1), sans que la tension à ses bornes n'ait le temps d'atteindre la tension de commande de sorte à ne pas déclencher l'ouverture de ladite branche (1c) d'émission pour permettre ou maintenir la circulation du courant électrique dans ladite résistance (R1) d'émission,
- lorsque ladite sortie (10a) d'émission est transitoirement, entre deux pulses, mise dans un état de circuit ouvert, à décharger ledit condensateur (C1) de sorte à permettre ou maintenir la circulation du courant électrique dans ladite résistance (R1) d'émission.

## Patentansprüche

1. Elektronische Vorrichtung zur Verwaltung eines KNX- oder Analog-Busses mit Schutz der elektronischen Komponente, wobei die Vorrichtung eine elektronische Hauptschaltung (1) mit gepulstem Strom aufweist, die geeignet und bestimmt ist, die Übertragung von Daten in einem KNX- oder Analog-Bus zu verwalten, in dem eine Gleichstromversorgung mit den Daten überlagert ist, wobei die elektronische Hauptschaltung (1) einerseits eine elektronische Datenübertragungsschaltung (1a) mit einem Übertragungsausgang (10a) aufweist und geeignet und bestimmt ist, dem Übertragungsausgang (10a) ein gepulstes Datenübertragungssignal zuzuführen, und andererseits einen Verbindungspunkt (1b) mit dem Bus, um die Daten an diesen zu übertragen, und einen Übertragungswiderstand (R1) oder ein anderes Element zur Begrenzung des analogen Stroms, durch den/das das Signal läuft, wobei der Übertragungsausgang (10a) bei jedem Impuls vorübergehend in einen Kurzschlusszustand versetzt wird, indem er in der elektronischen Datenübertragungsschaltung (1a) mit der Masse (M) kurzgeschlossen wird, und zwischen zwei Impulsen in einen Zustand mit offenem Stromkreis versetzt wird, **dadurch gekennzeichnet, dass** er darüber hinaus eine elektronische Schutzschaltung (3, 4) aufweist, die so konfiguriert und mit der elektronischen Hauptschaltung (1) verbunden ist, dass sie den Zustand des Übertragungsausgangs (10a) überwacht, um einen Zustand des letzteren, den sogenannten permanenten Kurzschlusszustand, zu erfassen, in dem dieser permanent, d. h. mit einer Dauer, die mindestens größer ist als die eines Impulses oder einer Impulsfolge, infolge eines eventuellen Ausfalls der elektronischen Datenübertragungsschaltung (1a) mit der Masse (M) kurzgeschlossen ist, und sofort nach dem Erfassen eine Öffnung in einem Zweig (1c) der elektronischen Hauptschaltung (1) zwischen dem Übertragungsausgang (10a) und dem Verbindungspunkt (1b) auszulösen, wodurch sofort der Fluss des elektrischen Stroms durch den Übertragungswiderstand (R1) unterbrochen wird.

2. Elektronische Vorrichtung, nach Anspruch 1, **dadurch gekennzeichnet, dass** die Schutzschaltung (3, 4) einerseits eine elektronische Erfassungs- und Steuerschaltung (3) und andererseits einen elektronischen Schutzschalter (4) aufweist, der in den Zweig (1c) geschaltet und so konfiguriert ist, dass er in einen Schließzustand, in dem der Strom in dem Zweig (1c) fließen kann, und in einen Öffnungszustand, der das Öffnen des Zweigs (1c) auslöst, gesteuert werden kann, wobei die Erfassungs- und Steuerschaltung (3) so konfiguriert ist, dass sie den permanenten Kurzschlusszustand erfasst und infolge der Erfassung den elektronischen Schutzschalter (4) sofort so steuert, dass er in den offenen Zustand versetzt wird und im geschlossenen Zustand gehalten wird, wenn der Übertragungsausgang (10a) vorübergehend in den Kurzschlusszustand versetzt wird.

3. Elektronische Vorrichtung, nach Anspruch 2, **dadurch gekennzeichnet, dass** der elektronische Schutzschalter (4) in dem Zweig (1c) zwischen dem Übertragungswiderstand (R1) und dem Verbindungspunkt (1b) angeschlossen ist.

4. Elektronische Vorrichtung, nach Anspruch 2 oder 3, **dadurch gekennzeichnet, dass** der elektronische Schutzschalter (4) eine Halbleitervorrichtung aus der Familie der Transistoren ist, wie etwa ein Feldeffekttransistor (T1) mit isoliertem Gate oder ein Bipolartransistor.

5. Elektronische Vorrichtung, nach einem der Ansprüche 2 bis 4, **dadurch gekennzeichnet, dass** die Erfassungs- und Steuerschaltung (3) eine elektronische Zeitdauermessvorrichtung aufweist, die geeignet ist, die Dauer des Kurzschlusszustands des Übertragungsausgangs (10a) zu messen, und dass die Erfassungs- und Steuerschaltung (3) so konfiguriert ist, dass sie die gemessene Zeitdauer verarbeitet, indem sie sie mit der Dauer eines Impulses oder einer Impulsfolge vergleicht, und, wenn diese gemessene Dauer größer ist als die Dauer eines Impulses oder einer Impulsfolge, um den elektronischen Schutzschalter (4) sofort zu steuern, um ihn in den offenen Zustand zu versetzen.

6. Elektronische Vorrichtung, nach Anspruch 5, **dadurch gekennzeichnet, dass** die Erfassungs- und Steuerschaltung (3) einen Mikrocontroller oder eine andere analoge integrierte Schaltung aufweist, die für die Zeitdauermessung verwendet wird, und dass der Mikrocontroller oder die analoge integrierte Schaltung die Zeitdauermessvorrichtung einschließt.

7. Elektronische Vorrichtung nach einem der Ansprüche 2 bis 4, **dadurch gekennzeichnet, dass** die Erfassungs- und Steuerschaltung (3) eine elektronische Schaltung ist, die im Wesentlichen auf Halbleiterbauelementen (T2) aus der Familie der Transistoren, Widerständen (R2, R3, R4, R5, R6, R7, R8) und Kondensatoren (C1, C2, C3) basiert, und dass die Erfassungs- und Steuerschaltung (3) so konfiguriert ist, dass der oder einer der Kondensator (en) (C1):
- bei Erkennung des permanenten Kurzschlusszustands auflädt, bis die Spannung an seinen Anschlüssen eine Spannung, die sogenannte Steuerspannung, erreicht, die bewirkt, dass der elektronische Schutzschalter (4) in den offenen Zustand versetzt wird,
- wenn der Übertragungsausgang (10a) vorübergehend in den Kurzschlusszustand versetzt wird, sich bei jedem Impuls auflädt, ohne dass die Spannung an seinen Anschlüssen Zeit hat, die Steuerspannung zu erreichen, so dass der elektronische Schutzschalter (4) gehalten oder in den Schließzustand versetzt wird,
- wenn der Übertragungsausgang (10a) vorübergehend zwischen zwei Impulsen in einen Zustand mit offenem Stromkreis versetzt wird, sich entlädt, so dass der elektronische Schutzschalter (4) gehalten oder in den geschlossenen Zustand versetzt wird.

8. Verfahren zum Schutz einer elektronischen Komponente in einer elektronischen Vorrichtung zur Verwaltung eines KNX- oder Analog-Busses, wobei die Vorrichtung eine elektronische Hauptschaltung (1) mit gepulstem Strom aufweist, die geeignet und bestimmt ist, die Übertragung von Daten in einem KNX- oder Analog-Bus zu verwalten, in dem eine Gleichstromversorgung mit den Daten überlagert ist, wobei die elektronische Hauptschaltung (1) einerseits eine elektronische Datenübertragungsschaltung (1a) mit einem Übertragungsausgang (10a) aufweist und geeignet und bestimmt ist, dem Übertragungsausgang (10a) ein gepulstes Datenübertragungssignal zuzuführen, und andererseits einen Verbindungspunkt (1b) mit dem Bus, um die Daten an diesen zu übertragen, und einen Übertragungswiderstand (R1) oder ein anderes Element zur Begrenzung des analogen Stroms, durch den/das das Signal läuft, wobei der Übertragungsausgang (10a) bei jedem Impuls vorübergehend in einen Kurzschlusszustand versetzt wird, indem er in der elektronischen Datenübertragungsschaltung (1a) mit der Masse (M) kurzgeschlossen wird, und zwischen zwei Impulsen in einen Zustand mit offenem Stromkreis versetzt wird, **dadurch gekennzeichnet, dass** es darin besteht, den Zustand des Übertragungsausgangs (10a) zu überwachen, um einen Zustand des Übertragungsausgangs (10a), den sogenannten permanenten Kurzschlusszustand, zu erfassen, in dem dieser permanent, d. h. mit einer Dauer, die mindestens größer ist als die eines Impulses oder einer Impulsfolge, infolge eines eventuellen Ausfalls der elektronischen Datenübertragungsschaltung (1a) mit der Masse (M) kurzgeschlossen ist, und sofort nach dem Erfassen eine Öffnung in einem Zweig (1c) der elektronischen Hauptschaltung (1) zwischen dem Übertragungsausgang (10a) und dem Verbindungspunkt (1b) auszulösen, wodurch sofort der Fluss des elektrischen Stroms durch den Übertragungswiderstand (R1) unterbrochen wird.

9. Verfahren nach Anspruch 8, **dadurch gekennzeichnet, dass** es darin besteht, die Dauer des Kurzschlusszustands des Übertragungsausgangs (10a) zu messen, die gemessene Dauer zu verarbeiten, indem sie mit der Dauer eines Impulses oder einer Impulsfolge verglichen wird, und, wenn diese gemessene Dauer größer als die Dauer eines Impulses oder einer Impulsfolge ist, sofort das Öffnen des Zweigs 1c auszulösen, um sofort den Fluss des elektrischen Stroms durch den Übertragungswiderstand (R1) zu unterbrechen.

10. Verfahren nach Anspruch 8, **dadurch gekennzeichnet, dass** es darin besteht:
- während des permanenten Kurzschlusszustands einen Kondensator (C1) zu laden, bis die Spannung an seinen Anschlüssen eine Spannung, die sogenannte Steuerspannung, erreicht, die bewirkt, dass das Öffnen des Zweigs (1c) ausgelöst wird, um sofort den Fluss des elektrischen Stroms durch den Übertragungswiderstand (R1) zu unterbrechen,
- wenn der Übertragungsausgang (10a) vorübergehend in den Kurzschlusszustand versetzt wird, bei jedem Impuls den Kondensator (C1) zu laden, ohne dass die Spannung an seinen Anschlüssen Zeit hat, die Steuerspannung zu erreichen, so dass das Öffnen des Übertragungszweigs (1c) nicht ausgelöst wird, um den Fluss des elektrischen Stroms durch den Übertragungswiderstand (R1) zu ermöglichen oder aufrechtzuerhalten,
- wenn der Übertragungsausgang (10a) zwischen zwei Impulsen vorübergehend in einen Zustand mit offenem Stromkreis versetzt wird, den Kondensator (C1) zu entladen, um den Fluss des elektrischen Stroms durch den Übertragungswiderstand (R1) zu ermöglichen oder aufrechtzuerhalten.

## Claims

1. Electronic device for managing a KNX bus or the like, with electronic component protection, said device comprising a pulsed-current main electronic circuit (1) able and intended to manage the transmission of data in a KNX bus or the like in which a DC power supply is superposed with said data, said main electronic circuit (1) comprising, on the one hand, an electronic data-transmission circuit (1a) comprising a transmission output (10a) and being able and intended to deliver a pulsed data-transmission signal to said transmission output (10a), and, on the other hand, a connection point (1b) to said bus for transmitting said data thereto, and a transmission resistor (R1), or other similar current-limiting element, through which said signal passes, said transmission output (10a) being transiently put, at each pulse, into a short-circuit state by being short-circuited to ground (M) in said electronic data-transmission circuit (1a) and, between two pulses, into an open-circuit state, **characterized in that** it further comprises an electronic protection circuit (3, 4) configured and connected to said main electronic circuit (1) so as to monitor the state of said transmission output (10a) to detect a state thereof, referred to as a permanent short-circuit state, where said output is short-circuited to ground (M) permanently, that is to say for a duration of at least greater than that of a pulse or a pulse train, following a possible failure of the electronic data-transmission circuit (1a) and to instantaneously trigger, following said detection, an opening in a branch (1c) of said main electronic circuit (1), between said transmission output (10a) and the connection point (1b), having the effect of instantaneously interrupting the flow of the electric current through said transmission resistor (R1).

2. Electronic device according to Claim 1, **characterized in that** the protection circuit (3, 4) comprises, on the one hand, an electronic detection and control circuit (3) and, on the other hand, an electronic protection switch (4) connected in said branch (1c) and configured to be controlled into a closed state allowing the current to flow through said branch (1c) and into an open state triggering the opening of said branch (1c), said detection and control circuit (3) being configured so as to detect the permanent short-circuit state and, following said detection, to instantaneously control the electronic protection switch (4) to put it in the open state and to keep it in the closed state when said transmission output (10a) is transiently put in the short-circuit state.

3. Electronic device according to Claim 2, **characterized in that** the electronic protection switch (4) is connected in the branch (1c) between the transmission resistor (R1) and the connection point (1b).

4. Electronic device according to Claim 2 or 3, **characterized in that** the electronic protection switch (4) is a semiconductor device of the family of transistors such as an insulated-gate field-effect transistor (T1) or a bipolar transistor.

5. Electronic device according to any one of Claims 2 to 4, **characterized in that** the detection and control circuit (3) comprises an electronic duration-measuring device able to measure the duration of the short-circuit state of the transmission output (10a) and **in that** said detection and control circuit (3) is configured to process said measured duration by comparing it with the duration of a pulse or a pulse train and, when this measured duration is greater than said duration of a pulse or a pulse train, to instantaneously control the electronic protection switch (4) in order to put it in the open state.

6. Electronic device according to Claim 5, **characterized in that** the detection and control circuit (3) comprises a microcontroller or any other similar integrated circuit used for measuring duration and **in that** said microcontroller, or similar integrated circuit, includes said duration-measuring device.

7. Electronic device according to any one of Claims 2 to 4, **characterized in that** the detection and control circuit (3) is an electronic circuit essentially based on one or more semiconductor devices (T2) of the family of transistors, one or more resistors (R2, R3, R4, R5, R6, R7, R8) and one or more capacitors (C1, C2, C3) and **in that** the detection and control circuit (3) is configured such that the or one of the capacitors (C1):
- upon detection of the permanent short-circuit state, is charged until the voltage across its terminals reaches a voltage, called the control voltage, which has the effect of putting the electronic protection switch (4) in the open state,
- when the transmission output (10a) is transiently put in the short-circuit state, is charged, at each pulse, without the voltage across its terminals having the time to reach said control voltage such that the electronic protection switch (4) is kept or put in the closed state,
- when said transmission output (10a) is transiently, between two pulses, put in an open-circuit state, is discharged such that the electronic protection switch (4) is kept or put in the closed state.

8. Method for protecting an electronic component in an electronic device for managing a KNX bus or the like, said device comprising a pulsed-current main electronic circuit (1) able and intended to manage the transmission of data in a KNX bus or the like in which a DC power supply is superposed with said data, said main electronic circuit (1) comprising, on the one hand, an electronic data-transmission circuit (1a) comprising a transmission output (10a) and being able and intended to deliver a pulsed data-transmission signal to said transmission output (10a), and, on the other hand, a connection point (1b) to said bus for transmitting said data thereto, and a transmission resistor (R1), or other similar current-limiting element, through which said signal passes, said transmission output (10a) being transiently put, at each pulse, into a short-circuit state by being short-circuited to ground (M) in said electronic data-transmission circuit (1a) and, between two pulses, into an open-circuit state, **characterized in that** it consists in monitoring the state of said transmission output (10a) to detect a state of the transmission output (10a), referred to as a permanent short-circuit state, where said output is short-circuited to ground (M) permanently, that is to say for a duration of at least greater than that of a pulse or a pulse train, following a possible failure of the electronic data-transmission circuit (1a) and to instantaneously trigger, following said detection, an opening in a branch (1c) of said main electronic circuit (1), between said transmission output (10a) and the connection point (1b), having the effect of instantaneously interrupting the flow of the electric current through said transmission resistor (R1).

9. Method according to Claim 8, **characterized in that** it consists in measuring the duration of the short-circuit state of the transmission output (10a), in processing said measured duration by comparing it with the duration of a pulse or a pulse train and, when this measured duration is greater than said duration of a pulse or a pulse train, in instantaneously triggering the opening in said branch 1c in order to instantaneously interrupt the flow of the electric current through said transmission resistor (R1).

10. Method according to Claim 8, **characterized in that** it consists:
- during the permanent short-circuit state, in charging a capacitor (C1) until the voltage across its terminals reaches a voltage, called the control voltage, which has the effect of triggering the opening of said branch (1c) in order to instantaneously interrupt the flow of the electric current through said transmission resistor (R1),
- when said transmission output (10a) is transiently put in the short-circuit state, in charging, at each pulse, said capacitor (C1) without the voltage across its terminals having the time to reach the control voltage so as not to trigger the opening of said transmission branch (1c) to allow or keep the flow of the electric current through said transmission resistor (R1),
- when said transmission output (10a) is transiently, between two pulses, put in an open-circuit state, in discharging said capacitor (C1) so as to allow or keep the flow of the electric current through said transmission resistor (R1).
